# EUROPEAN PATENT APPLICATION

(11) **EP 4 769 242 A1**
(43) Date of publication of application: **01.07.2026**
(21) Application number: 25225287.9
(22) Date of filing: 18.12.2025
(51) Int. Cl.: G06N 10/40, H10N 69/00

(54) **QUANTUM DEVICE, QUANTUM COMPUTING SYSTEM, AND READOUT METHOD FOR QUANTUM DEVICE**

(30) Priority: 24.12.2024 JP 2024227017
(71) Applicant: FUJITSU LIMITED, Kawasaki-shi, Kanagawa 211-8588 (JP)
(72) Inventor: SAIDA, Daisuke, Kawasaki-shi, 211-8588 (JP); TAMATE, Shuhei, Wako-shi, 351-0198 (JP)
(74) Representative: Haseltine Lake Kempner LLP

(57) **Abstract**

A quantum device includes a first qubit circuit, a second qubit circuit, and a cover chip. The first qubit circuit includes a first port, a first qubit, and a first resonator coupled to the first qubit and the first port and having a first resonant frequency. The second qubit circuit includes a second port, a second qubit, and a second resonator coupled to the second qubit and the second port and having a second resonant frequency different from the first resonant frequency. The cover chip includes a waveguide coupled to the first port and the second port.

## Description

### FIELD

The embodiments discussed herein are related to quantum devices, quantum computing systems, and readout methods for quantum devices.

### BACKGROUND

Conventionally, there is a proposed quantum device in which multiple quantum bits (or qubits) are coupled to a single readout port provided in a quantum bit circuit (or qubit circuit), and multiplexed readout through the single readout port is enabled, that is, multi-qubit readout through the single readout port is supported..

Related art include U.S. Patent Application Publication No. 2021/342729, U.S. Patent No. 10,068,181, International Publication Pamphlet No. WO 2023/132063, Japanese National Publication of International Patent Application No. 2019-532520, and Japanese Laid-Open Patent Publication No. 2022-172189 (Japanese Patent No. 7359476), for example.

There are demands for performing multiplexed readout on a plurality of qubit circuits.

### SUMMARY

Accordingly, it is an object in one aspect of the embodiments to provide a quantum device, a quantum computing system, and a readout method for the quantum device, which are capable of performing multiplexed readout on a plurality of qubit circuits.

According to an aspect of the embodiments, a quantum device includes a first qubit circuit; a second qubit circuit; and a cover chip, wherein the first qubit circuit includes a first port; a first qubit; and a first resonator coupled to the first qubit and the first port and having a first resonant frequency, the second qubit circuit includes a second port; a second qubit; and a second resonator coupled to the second qubit and the second port and having a second resonant frequency different from the first resonant frequency, and the cover chip includes a waveguide coupled to the first port and the second port.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1 is a first cross sectional view illustrating a quantum device according to a first embodiment;
FIG. 2 is a second cross sectional view illustrating the quantum device according to the first embodiment;
FIG. 3 is a third cross sectional view illustrating the quantum device according to the first embodiment;
FIG. 4 is a top view illustrating a first quantum bit circuit and a second quantum bit circuit in the quantum device according to the first embodiment;
FIG. 5 is a bottom view illustrating a cover chip in the quantum device according to the first embodiment;
FIG. 6 is a first cross sectional view illustrating a first example of a readout method for the quantum device according to the first embodiment;
FIG. 7 is a second cross sectional view illustrating the first example of the readout method for the quantum device according to the first embodiment;
FIG. 8 is a third cross sectional view illustrating the first example of the readout method for the quantum device according to the first embodiment;
FIG. 9 is a first diagram illustrating characteristics of a traveling-wave parametric amplifier;
FIG. 10 is a second diagram illustrating the characteristics of the traveling-wave parametric amplifier;
FIG. 11 is a third diagram illustrating the characteristics of the traveling-wave parametric amplifier;
FIG. 12 is a firs cross sectional view illustrating a second example of the readout method for the quantum device according to the first embodiment;
FIG. 13 is a second cross sectional view illustrating the second example of the readout method for the quantum device according to the first embodiment;
FIG. 14 is a third cross sectional view illustrating the second example of the readout method for the quantum device according to the first embodiment;
FIG. 15 is a first cross sectional view illustrating the quantum device according to a second embodiment;
FIG. 16 is a second cross sectional view illustrating the quantum device according to the second embodiment;
FIG. 17 is a third cross sectional view illustrating the quantum device according to the second embodiment;
   FIG. 18 is a first cross sectional view illustrating the quantum device according to a third embodiment;
FIG. 19 is a second cross sectional view illustrating the quantum device according to the third embodiment;
FIG. 20 is a third cross sectional view illustrating the quantum device according to the third embodiment;
FIG. 21 is a first cross sectional view illustrating the quantum device according to a fourth embodiment;
FIG. 22 is a second cross sectional view illustrating the quantum device according to the fourth embodiment;
FIG. 23 is a third cross sectional view illustrating the quantum device according to the fourth embodiment;
FIG. 24 is a first cross sectional view illustrating the quantum device according to a fifth embodiment;
FIG. 25 is a second cross sectional view illustrating the quantum device according to the fifth embodiment;
FIG. 26 is a third cross sectional view illustrating the quantum device according to the fifth embodiment;
FIG. 27 is a first cross sectional view illustrating the quantum device according to a sixth embodiment;
FIG. 28 is a second cross sectional view illustrating the quantum device according to the sixth embodiment;
FIG. 29 is a third cross sectional view illustrating the quantum device according to the sixth embodiment;
FIG. 30 is a cross sectional view illustrating the quantum device according to a seventh embodiment;
FIG. 31 is a cross sectional view illustrating the quantum device according to an eighth embodiment;
FIG. 32 is a cross sectional view illustrating the quantum device according to a ninth embodiment;
FIG. 33 is a cross sectional view illustrating the quantum device according to a tenth embodiment;
FIG. 34 is a cross sectional view illustrating the quantum device according to an eleventh embodiment;
FIG. 35 is a cross sectional view illustrating the quantum device according to a twelfth embodiment;
FIG. 36 is a bottom view illustrating a first modification of the cover chip; and
FIG. 37 is a bottom view illustrating a second modification of the cover chip.

### DESCRIPTION OF EMBODIMENTS

Hereinafter, embodiments of the present disclosure will be described with reference to the accompanying drawings. In the present specification and the drawings, constituent elements or components having substantially the same functional configuration are designated by the same reference numerals, and a redundant description thereof may be omitted. In the following description, an XYZ orthogonal coordinate system is used for the sake of convenience to simplify the description, and the coordinate system used does not limit an orientation in which the quantum device is used. Further, when viewed from an arbitrary point, a +Z-side may be referred to as upward, upper side, up or above, and a -Z-side may be referred to as downward, lower side, down or below. In addition, a plan view of an object refers to a view of the object viewed from the +Z-side, and a planar shape of the object refers to a shape of the object in the plan view viewed from the +Z-side.

### <First Embodiment>

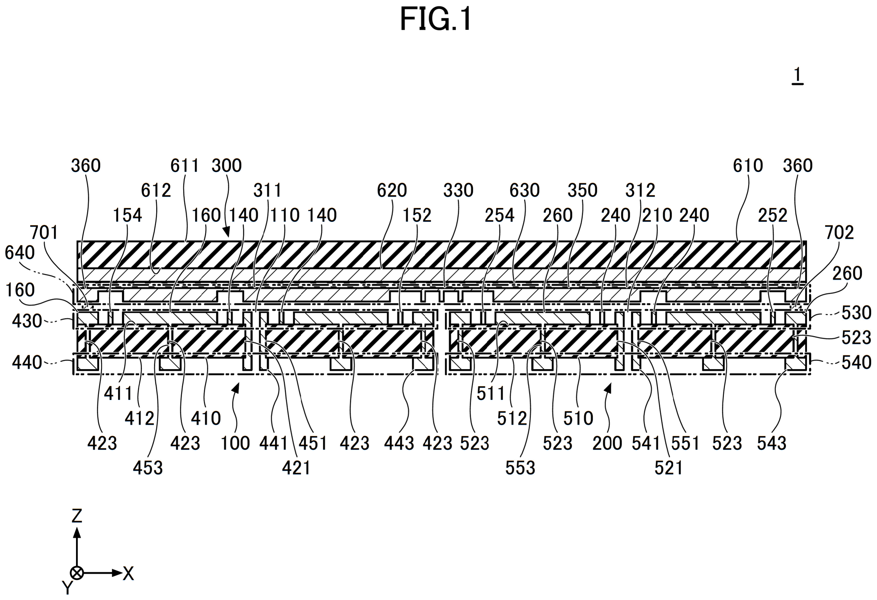

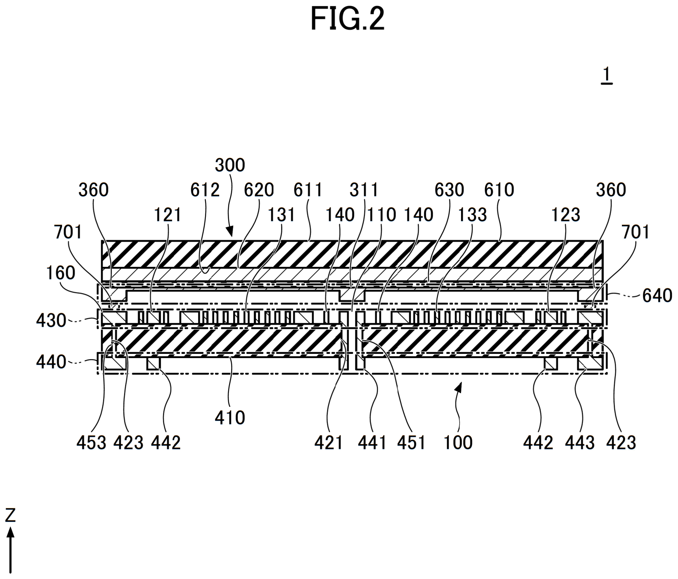

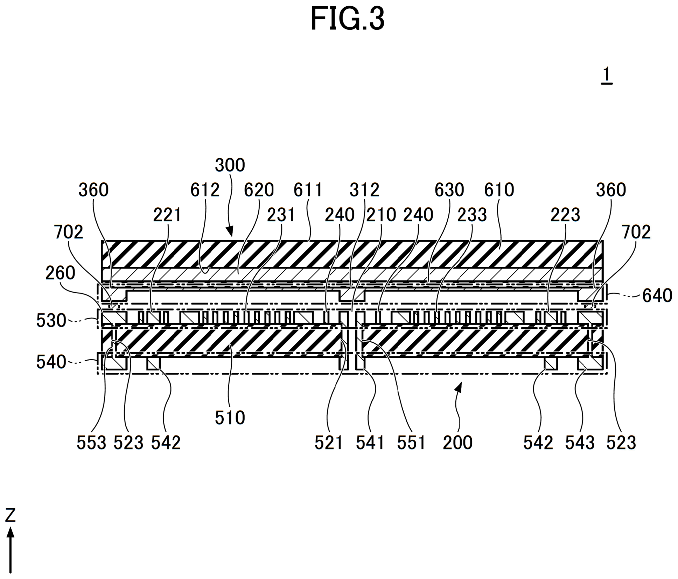

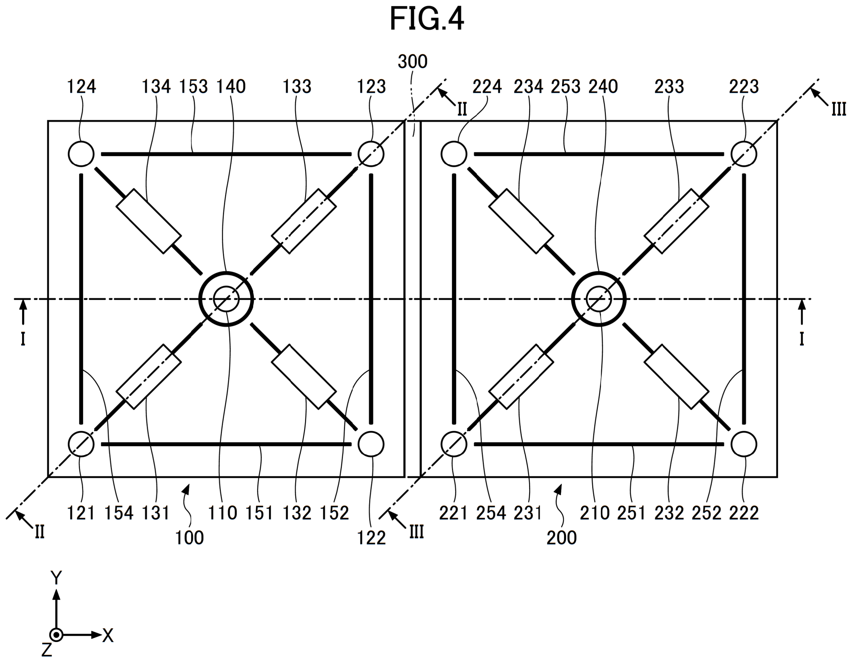

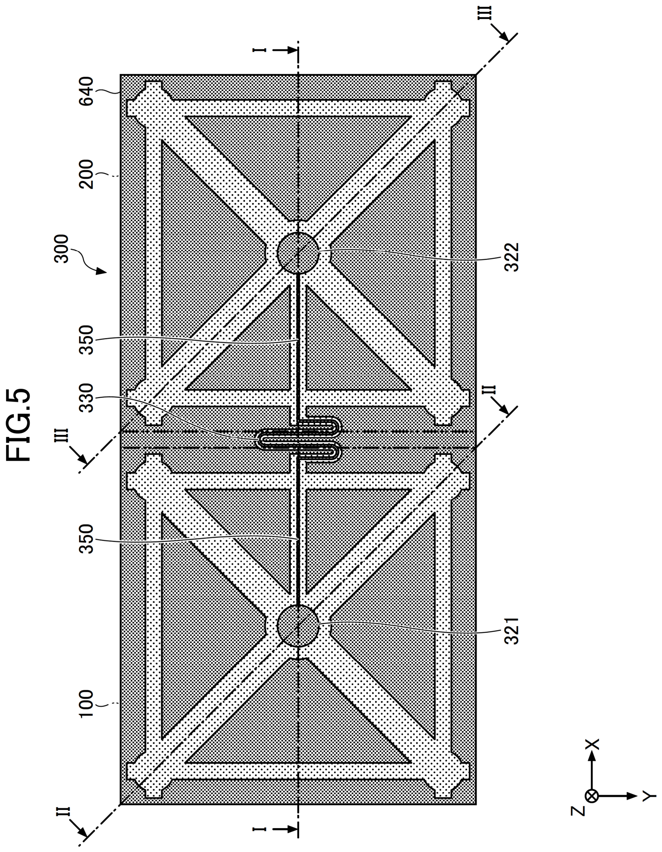

A first embodiment will be described. The first embodiment relates to a quantum device. FIG. 1, FIG. 2, and FIG. 3 are cross sectional views illustrating the quantum device according to the first embodiment. FIG. 4 is a top view illustrating a first qubit circuit and a second qubit circuit in the quantum device according to the first embodiment. FIG. 5 is a bottom view illustrating a cover chip in the quantum device according to the first embodiment. FIG. 1 corresponds to a cross sectional view taken along line I-I in FIG. 4 and FIG. 5. FIG. 2 corresponds to a cross sectional view taken along line II-II in FIG. 4 and FIG. 5. FIG. 3 corresponds to a cross sectional view taken along a line III-III in FIG. 4 and FIG. 5. FIG. 1 through FIG. 5 or the like illustrate only portions of the quantum device, and a side end portion in each figure does not illustrate a side end portion of the quantum device. Further, the quantum device can have a larger number of qubit circuits.

As illustrated in FIG. 1 through FIG. 5, a quantum device 1 according to the first embodiment includes a first qubit circuit 100, a second qubit circuit 200, and a cover chip 300. In this embodiment, the first qubit circuit 100 and the second qubit circuit 200 are provided on the same chip.

The first qubit circuit 100 includes a substrate 410, a conductive layer 430, and a conductive layer 440. The substrate 410 is a silicon (Si) substrate, a sapphire substrate, or a MgO substrate, for example. A dielectric loss of the substrate 410 is preferably 1 × 10⁻³ or less, and more preferably 1 × 10⁻⁴ or less. The dielectric loss of the substrate 410 varies with temperature. In order to suppress deterioration of the characteristics of the first qubit circuit 100 due to the dielectric loss caused by the substrate 410, the dielectric loss is preferably 1 × 10⁻⁶ or less under a cryogenic temperature environment ranging from 1 mK to around 100 mK, for example. A resistivity of the substrate 410 is preferably 0.1 kΩ·cm or higher, and more preferably 1 kΩ·cm or higher. The substrate 410 has an upper surface 411 on the +Z-side, and a lower surface 412 on the -Z-side. A through hole 421 for input/output and a plurality of through holes 423 for grounding are formed in the substrate 410. The first qubit circuit 100 includes a conductive layer 451 covering an inner wall surface of the through hole 421, and a conductive layer 453 provided in each through hole 423.

The conductive layer 430 is provided on the upper surface 411 of the substrate 410. The conductive layer 430 includes a first port 110, four qubits 121, 122, 123, and 124 within the first qubit circuit 100, four resonators 131, 132, 133, and 134 within the first qubit circuit 100, a first filter 140, four bit-to-bit interconnects 151, 152, 153, and 154, and a ground interface 160. The qubits 121 through 124 are examples of first qubits, and the resonators 131 through 134 are examples of first resonators.

The qubits 121 through 124 are arranged at vertices of a square in the plan view, and the first port 110 is arranged at a center of the square in the plan view. The qubit 122 is arranged on the +X-side of the qubit 121, the qubit 123 is arranged on the +Y-side of the qubit 122, the qubit 124 is arranged on the -X-side of the qubit 123, and the qubit 121 is arranged on the -Y-side of the qubit 124. The first port 110 is connected to the conductive layer 451.

The resonator 131 is disposed between the qubit 121 and the first port 110. The resonator 132 is disposed between the qubit 122 and the first port 110. The resonator 133 is disposed between the qubit 123 and the first port 110. The resonator 134 is disposed between the qubit 124 and the first port 110. The resonator 131 is coupled to the qubit 121, the resonator 132 is coupled to the qubit 122, the resonator 133 is coupled to the qubit 123, and the resonator 134 is coupled to the qubit 124. The resonators 131 through 134 have mutually different first resonant frequencies. For example, the first resonant frequencies differ from one another by approximately 100 MHz. For example, the resonators 131 through 134 have a meander shape in the plan view.

The first filter 140 is disposed between the first port 110 and the resonators 131 through 134, and is coupled to the first port 110 and to the resonators 131 through 134. The resonators 131 through 134 are coupled to the first port 110 via the first filter 140. The first filter 140 is a Purcell filter, for example. The Purcell filter may be provided for each of the resonators 131 through 134. In this case, the first port 110 is directly or indirectly coupled to each Purcell filter. The indirect coupling of the first port 110 to each Purcell filter may be a capacitive coupling or an inductive coupling, or may include both the capacitive coupling and the inductive coupling.

The bit-to-bit interconnect 151 extends parallel to the X-axis and is coupled to the qubits 121 and 122. The bit-to-bit interconnect 152 extends parallel to the Y-axis and is coupled to the qubits 122 and 123. The bit-to-bit interconnect 153 extends parallel to the X-axis and is coupled to the qubits 123 and 124. The bit-to-bit interconnect 154 extends parallel to the Y-axis and is coupled to the qubits 124 and 121. The bit-to-bit interconnect directly or indirectly couples two qubits. For example, the indirect coupling of the two qubits may be a capacitive coupling, an inductive coupling, or may include both the capacitive coupling and the inductive coupling. The bit-to-bit interconnect is also referred to as a coupler. A strength of the coupling between the qubits (or a qubit-qubit coupling strength) may be fixed or variable.

Although not illustrated in FIG. 4, the ground interface 160 is disposed in a periphery of the first port 110, the qubits 121 through 124, the resonators 131 through 134, the first filter 140, and the bit-to-bit interconnects 151 through 154. The ground interface 160 is connected to the conductive layer 453.

The conductive layer 440 is provided on the lower surface 412 of the substrate 410. The conductive layer 440 includes a readout signal input/output interface 441, four qubit control signal input interfaces 442, and a plurality of ground interfaces 443.

The four qubit control signal input interfaces 442 are arranged on the -Z-side of the qubits 121 through 124, respectively, and overlap the qubits 121 through 124 in the plan view. The four qubit control signal input interfaces 442 do not necessarily have to overlap the qubits 121 through 124 in the plan view. The four qubit control signal input interfaces 442 are coupled to the qubits 121 through 124, respectively. Control signals for the qubits 121 through 124 are input to the qubit control signal input interfaces 442. The readout signal input/output interface 441 is connected to the conductive layer 451. The readout signal input/output interface 441 is electrically connected to the first port 110 via the conductive layer 451. The ground interfaces 443 are connected to the conductive layer 453. The ground interfaces 443 are electrically connected to the ground interface 160 via the conductive layer 453.

The conductive layers 430, 440, 451, and 453 are formed of a material that becomes superconducting at cryogenic temperatures, such as aluminum (Al), niobium (Nb), tantalum (Ta), or titanium nitride (TiN), for example.

The second qubit circuit 200 includes a substrate 510, a conductive layer 530, and a conductive layer 540. The substrate 510 is a Si substrate, a sapphire substrate, or a magnesium oxide (MgO) substrate, for example. A dielectric loss of the substrate 510 is preferably 1 × 10⁻³ or less, and more preferably 1 × 10⁻⁴ or less. The dielectric loss of the substrate 510 varies with temperature. In order to suppress deterioration of the characteristics of the first qubit circuit 100 due to the dielectric loss caused by the substrate 510, the dielectric loss is preferably 1 × 10⁻⁶ or less under the cryogenic temperature environment ranging from 1 mK to around 100 mK, for example. A resistivity of the substrate 510 is preferably 0.1 kΩ·cm or higher, and more preferably 1 kΩ·cm or higher. The substrate 510 has an upper surface 511 on the +Z-side and a lower surface 512 on the -Z-side. A through hole 521 for input/output and a plurality of through holes 523 for grounding are formed in the substrate 510. The second qubit circuit 200 includes a conductive layer 551 covering an inner wall surface of the through hole 521, and a conductive layer 553 provided in each through hole 523. For example, the substrates 410 and 510 may be configured by a single substrate.

The conductive layer 530 is provided on the upper surface 511 of the substrate 510. The conductive layer 530 includes a second port 210, four qubits 221, 222, 223, and 224 within the second qubit circuit 200, four resonators 231, 232, 233, and 234 within the second qubit circuit 200, a second filter 240, four bit-to-bit interconnects 251, 252, 253, and 254, and a ground interface 260. The qubits 221 through 224 are examples of second qubits, and the resonators 231 through 234 are examples of second resonators.

The qubits 221 through 224 are arranged at vertices of a square in the plan view, and the second port 210 is arranged at a center of the square in the plan view. The qubit 222 is arranged on the +X-side of the qubit 221, the qubit 223 is arranged on the +Y-side of the qubit 222, the qubit 224 is arranged on the -X-side of the qubit 223, and the qubit 221 is arranged on the -Y-side of the qubit 224. The second port 210 is connected to the conductive layer 551.

The resonator 231 is disposed between the qubit 221 and the second port 210. The resonator 232 is disposed between the qubit 222 and the second port 210. The resonator 233 is disposed between the qubit 223 and the second port 210. The resonator 234 is disposed between the qubit 224 and the second port 210. The resonator 231 is coupled to the qubit 221, the resonator 232 is coupled to the qubit 222, the resonator 233 is coupled to the qubit 223, and the resonator 234 is coupled to the qubit 224. The resonators 231 through 234 have mutually different second resonant frequencies. The first resonant frequencies and the second resonant frequencies are different among the four resonators 131 through 134 and the four resonators 231 through 234. For example, the second resonant frequencies may differ from one another by approximately 100 MHz. For example, the resonators 231 through 234 have a meander shape in the plan view.

The second filter 240 is disposed between the second port 210 and the resonators 231 through 234, and is coupled to the second port 210 and to the resonators 231 through 234. The resonators 231 through 234 are coupled to the second port 210 via the second filter 240. The second filter 240 is a Purcell filter, for example. The Purcell filter may be provided for each of the resonators 231 through 234. In this case, the second port 210 is directly or indirectly coupled to each Purcell filter.

The bit-to-bit interconnect 251 extends parallel to the X-axis and is coupled to the qubits 221 and 222. The bit-to-bit interconnect 252 extends parallel to the Y-axis and is coupled to the qubits 222 and 223. The bit-to-bit interconnect 253 extends parallel to the X-axis and is coupled to the qubits 223 and 224. The bit-to-bit interconnect 254 extends parallel to the Y-axis and is coupled to the qubits 224 and 221.

Although not illustrated in FIG. 4, a bit-to-bit interconnect is provided between the qubit 123 within the first qubit circuit 100 and the qubit 224 within the second qubit circuit 200, and a bit-to-bit interconnect is provided between the qubit 122 within the first qubit circuit 100 and the qubit 221 within the second qubit circuit 200. These bit-to-bit interconnects directly or indirectly couple two qubits. These bit-to-bit interconnects may be formed in the conductive layer 640 (refer to FIG. 5).

Although not illustrated in FIG. 4, the ground interface 260 is disposed in a periphery of the second port 210, the qubits 221 through 224, the resonators 231 through 234, the second filter 240, and the bit-to-bit interconnects 251 through 254. The ground interface 260 is connected to the conductive layer 553.

The conductive layer 540 is provided on the lower surface 512 of the substrate 510. The conductive layer 540 includes a readout signal input/output interface 541, four qubit control signal input interfaces 542, and a plurality of ground interfaces 543.

The four qubit control signal input interfaces 542 are arranged on the -Z-side of the qubits 221 through 224, respectively, and overlap the qubits 221 through 224 in the plan view. The four qubit control signal input interfaces 542 do not necessarily have to overlap the qubits 221 through 224 in the plan view. The four qubit control signal input interfaces 542 are coupled to the qubits 221 through 224, respectively. Control signals for the qubits 221 through 224 are input to the qubit control signal input interfaces 542. The readout signal input/output interface 541 is connected to the conductive layer 551. The readout signal input/output interface 541 is electrically connected to the second port 210 via the conductive layer 551. The ground interfaces 543 are connected to the conductive layer 553. The ground interfaces 543 are electrically connected to the ground interface 260 via the conductive layer 553.

The conductive layers 530, 540, 551, and 553 are formed of a material that becomes superconducting at the cryogenic temperatures, such as Al, Nb, Ta, or TiN, for example.

The cover chip 300 includes a substrate 610, a shield layer 620, an insulating film 630, and a conductive layer 640. The substrate 610 is a Si substrate, a sapphire substrate, or a MgO substrate, for example. The substrate 610 may be a Si substrate with a thermal oxide film. A dielectric loss of the substrate 610 is preferably 1 × 10⁻³ or less, and more preferably 1 × 10⁻⁴ or less. The dielectric loss of the substrate 610 varies with temperature. In order to suppress deterioration of the characteristics of the first qubit circuit 100 and the second qubit circuit 200 due to the dielectric loss caused by the substrate 610, the dielectric loss is preferably 1 × 10⁻⁶ or less in the cryogenic temperature environment ranging from 1 mK to around 100 mK, for example. A resistivity of the substrate 610 is preferably 0.1 kΩ·cm or higher, and more preferably 1 kΩ·cm or higher. The substrate 610 has an upper surface 611 on the +Z-side and a lower surface 612 on the -Z-side.

The shield layer 620 is provided on the lower surface 612 of the substrate 610, the insulating film 630 is provided on a lower surface of the shield layer 620, and the conductive layer 640 is provided on a lower surface of the insulating film 630. The insulating film 630 is provided between the shield layer 620 and the conductive layer 640. The shield layer 620 covers the first qubit circuit 100 and the second qubit circuit 200 from the +Z-side.

The conductive layer 640 includes a first port coupling interface 311 that faces the first port 110 and is coupled to the first port 110, a second port coupling interface 312 that faces the second port 210 and is coupled to the second port 210, a waveguide 350, and a ground interface 360. The waveguide 350 is a coplanar line, for example. The first port 110 and the first port coupling interface 311 are capacitively coupled to each other. The second port 210 and the second port coupling interface 312 are capacitively coupled to each other. The waveguide 350 is connected to the first port coupling interface 311 and the second port coupling interface 312. The waveguide 350 is capacitively coupled to the first port 110 and the second port 210. The waveguide 350 may include a third resonator 330. In a case where the waveguide 350 includes the third resonator 330, the third resonator 330 has a third resonant frequency. The ground interface 360 is provided in a periphery of the waveguide 350. The ground interface 160 and the ground interface 360 are bonded to each other by a conductive bump 701, and the ground interface 260 and the ground interface 360 are bonded to each other by a conductive bump 702. In the case where the waveguide 350 includes the third resonator 330, the third resonator 330 has a meander shape in the plan view. The third resonator 330 is preferably a λ/2 resonator having a third resonant frequency equal to an average value fₐᵥₑ of the first resonant frequencies of the resonators 131 through 134 and the second resonant frequencies of the resonators 231 through 234. The third resonant frequency may be fₐᵥₑ × 0.7 or higher and fₐᵥₑ × 1.3 or lower, by taking manufacturing errors into consideration. It is preferable that the capacitive coupling between the third resonator 330 and the first port 110 and the second port 210 is sufficiently large. When a maximum value and a minimum value of the first resonant frequencies and the second resonant frequencies are denoted by fₘₐₓ and fₘᵢₙ, respectively, an external line width of the third resonator 330 can include a range from fmin to fmax, so that a more suitable signal response can be obtained when states of the first qubit circuit 100 and the second qubit circuit 200 are multiplexed and read out. In the case where the waveguide 350 includes the third resonator 330, the third resonator 330 may be a Purcell filter.

In addition, concave portions recessed toward the +Z-side are formed in portions of the conductive layer 640 overlapping the qubits 121 through 124, overlapping the qubits 221 through 224, overlapping the resonators 131 through 134, overlapping the resonators 231 through 234, overlapping the bit-to-bit interconnects 151 through 154, and overlapping the bit-to-bit interconnects 251 through 254 in the plan view. Two or more concave portions may be connected.

The shield layer 620 and the conductive layer 640 are formed of a material that becomes superconducting at the cryogenic temperatures, such as Al, TiN, Ta, or Nb, for example, including an operating temperature of the qubits 121 through 124 and the qubits 221 through 224. The insulating film 630 is formed of an oxide of the material used for the shield layer 620, such as aluminum oxide or the like, or a nitride of the material used for the shield layer 620, such as aluminum nitride or the like, for example. The conductive bumps 701 and 702 are formed of indium (In), for example.

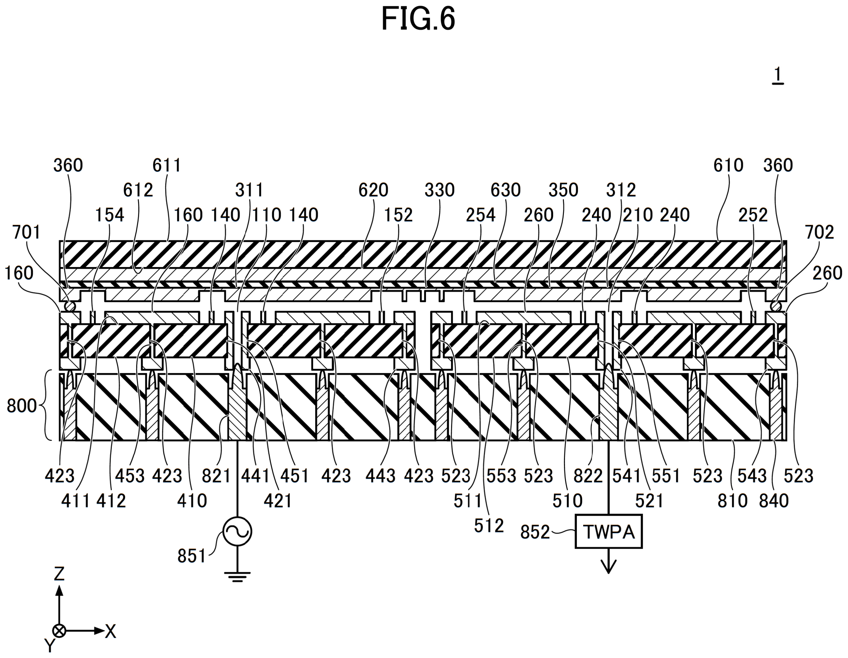

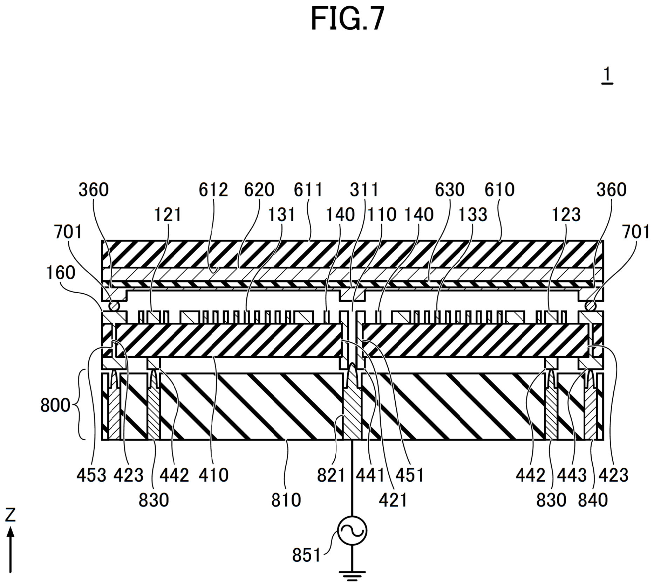

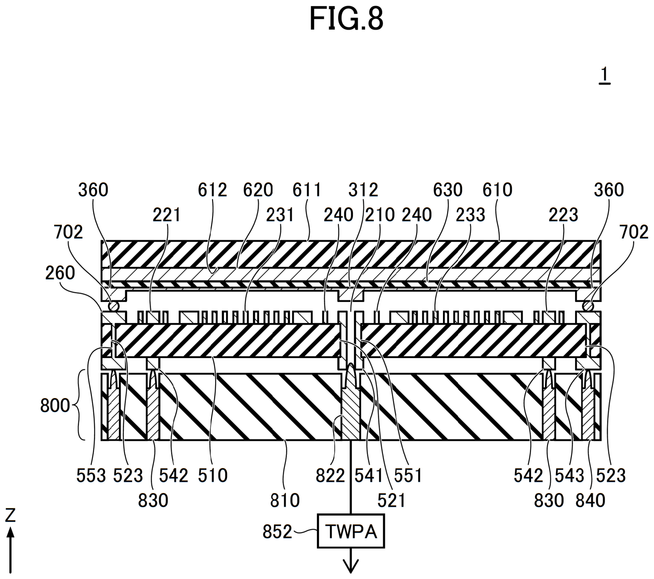

In use, the quantum device 1 is caused to make contact with probe pins, for example. FIG. 6, FIG. 7, and FIG. 8 are cross sectional views illustrating a first example of a readout method for the quantum device 1 according to the first embodiment.

As illustrated in FIG. 6 through FIG. 8, a probe card 800 includes a substrate 810, a readout signal input probe 821, a readout signal output probe 822, eight control signal input probes 830, and a plurality of ground probes 840. The readout signal input probe 821, the readout signal output probe 822, the control signal input probes 830, and the ground probes 840 may be fixed to the substrate 810 or may be detachable from the substrate 810. For example, the readout signal input probe 821, the readout signal output probe 822, the control signal input probes 830, and the ground probes 840 are coaxial pins, and have a mechanism for mechanical extension and retraction of the pins. For example, the readout signal input probe 821 is brought into contact with the readout signal input/output interface 441, and the readout signal output probe 822 is brought into contact with the readout signal input/output interface 541. The control signal input probes 830 are brought into contact with the qubit control signal input interfaces 442 or 542, and the ground probes 840 are brought into contact with the ground interfaces 443 or 543. A package structure capable of holding the probes may be used in place of the probe card 800.

A signal source 851 of a microwave signal is connected to the readout signal input probe 821, and an amplifier, such as a traveling-wave parametric amplifier (TWPA) 852, for example, is connected to the readout signal output probe 822. The amplifier may be a parametric amplifier using a Josephson junction or an amplifier using a kinetic inductance. A control device (or a controller) of the qubit is connected to the control signal input probes 830, and the ground probes 840 are grounded. A quantum computing system is configured in this manner.

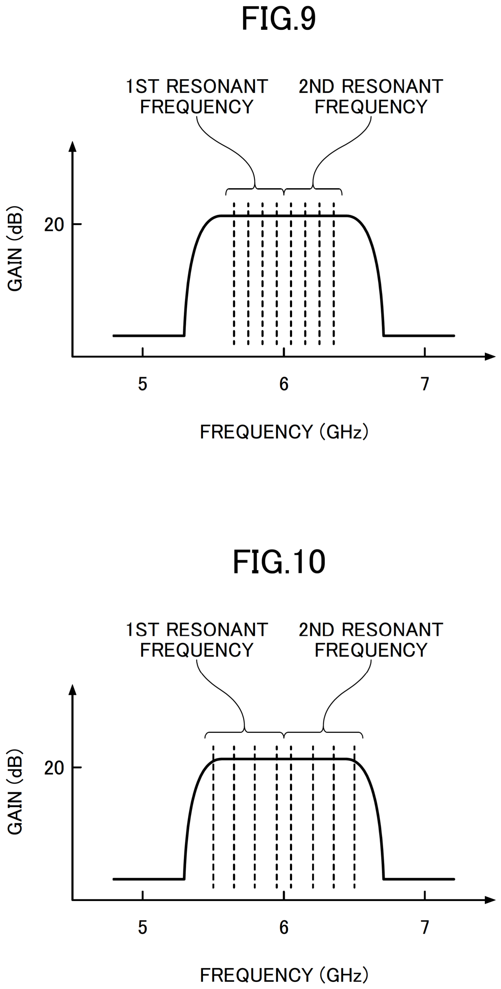

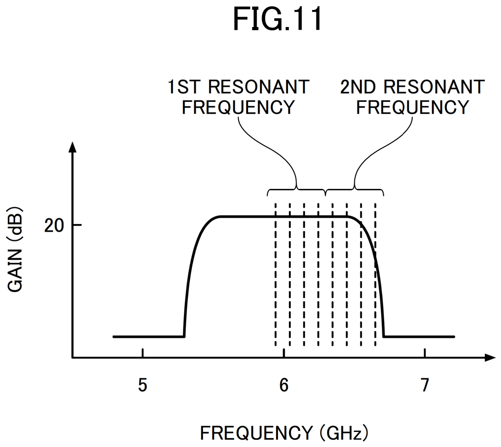

Next, the TWPA 852 will be described. FIG. 9, FIG. 10, and FIG. 11 are diagrams illustrating characteristics of the TWPA 852. A constant amplification bandwidth in which a gain of the TWPA 852 is 20 dB or higher preferably includes all of the four first resonant frequencies and the four second resonant frequencies, as illustrated in FIG. 9. In FIG. 9, the first resonant frequencies are grouped into low frequencies for the sake of convenience to facilitate understanding, but a combination of the first resonant frequencies and the second resonant frequencies is not limited to that illustrated in FIG. 9. Frequency assignment may be freely determined within a range in which all of the resonant frequencies are included in the amplification bandwidth of the TWPA 852. However, as illustrated in FIG. 10, even in a case where some of the first resonant frequencies and some of the second resonant frequencies are outside the amplification bandwidth, it is possible to solve the problem to be solved by the present disclosure. Further, as illustrated in FIG. 11, even in a case where some of the second resonant frequencies are outside the amplification bandwidth, it is possible to solve the problem to be solved by the present disclosure. Although not illustrated, the problem to be solved by the present disclosure can also be solved in a case where some of the first resonant frequencies are outside the amplification bandwidth.

When performing a readout from the quantum device 1, signals for controlling the states of the qubits 121 through 124 and the qubits 221 through 224 are supplied from the control signal input probes 830 to the qubits 121 through 124 and the qubits 221 through 224. A microwave signal is input to the first port 110, as a readout signal from the signal source 851, via the readout signal input/output interface 441. As for the frequency of the readout signal, signals corresponding to the eight resonant frequencies of the resonators 131 through 134 and the resonators 231 through 234 are frequency-multiplexed and input. When the readout signal is supplied, the readout signal superimposed with four state signals indicating the states of the qubits 121 through 124 is transmitted from the first port 110 to the first port coupling interface 311 in the first qubit circuit 100. The readout signal is further superimposed with four state signals indicating the states of the qubits 221 through 224 and is output from the second port 210 to the TWPA 852 via the readout signal input/output interface 541 in the second qubit circuit 200. In this state, the four state signals are superimposed at the second port 210 via the waveguide 350 and the second port coupling interface 312. The waveguide 350 may include a third resonator 330. The TWPA 852 amplifies the readout signal superimposed with the eight state signals. Then, the amplified signal (that is, the signal after the amplification) is measured by a signal processor or the like provided in the quantum computing system. Accordingly, it is possible perform the readout of the states of the four qubits 121 through 124 in the first qubit circuit 100 and states of the four qubits 221 through 224 in the second qubit circuit 200.

It is also possible to cause the readout signal input probe 821 to make contact with the readout signal input/output interface 541 and cause the readout signal output probe 822 to make contact with the readout signal input/output interface 441 so that the signals propagate in opposite directions.

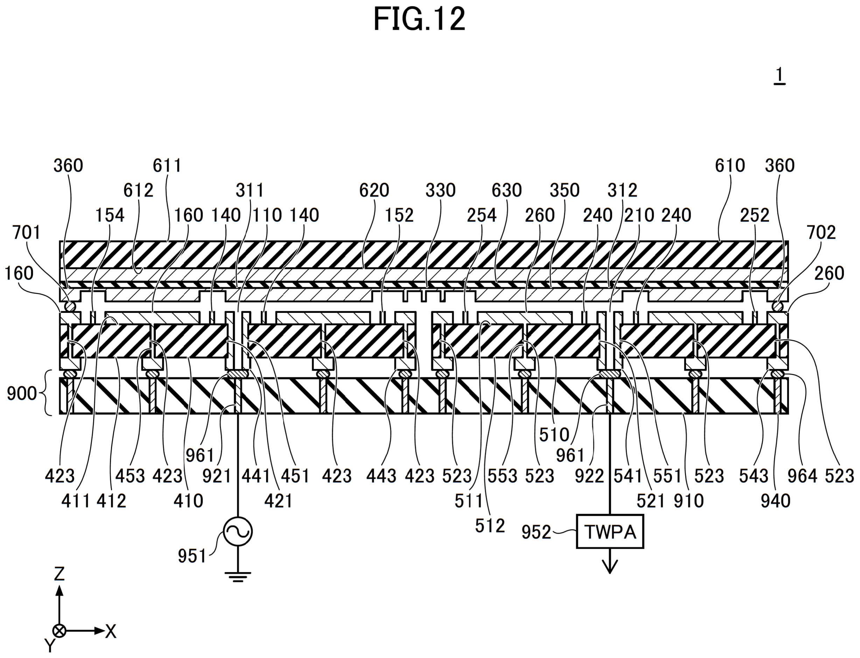

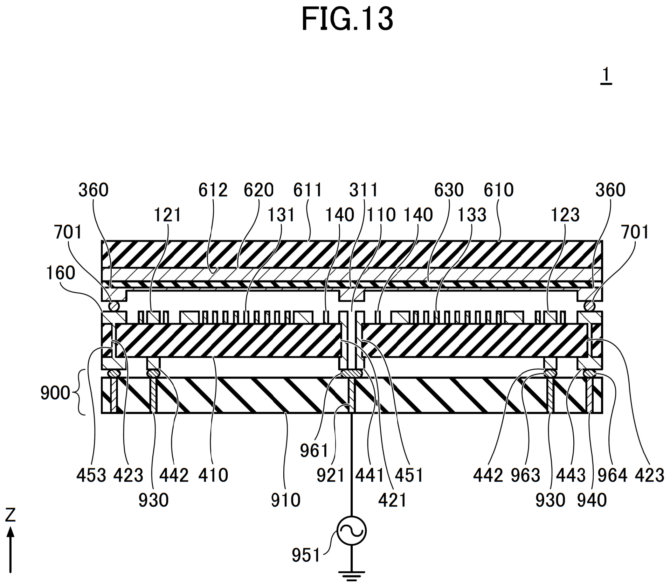

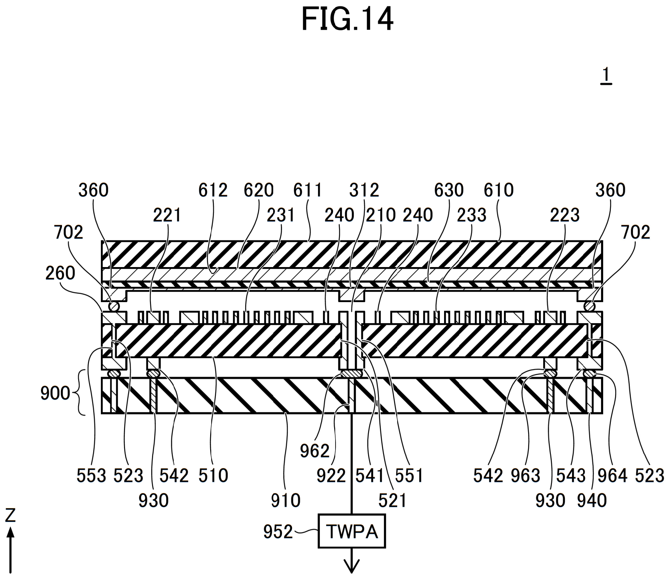

An interposer may be used in place of the probe card 800. FIG. 12, FIG. 13, and FIG. 14 are cross sectional views illustrating a second example of the readout method for the quantum device 1 according to the first embodiment.

As illustrated in FIG. 12 through FIG. 14, a structure 900 with an interposer includes a substrate 910, an input interconnect 921, a readout interconnect 922, eight control interconnects 930, and a plurality of ground interconnects 940. The input interconnect 921, the readout interconnect 922, the control interconnects 930, and the ground interconnects 940 are provided in the substrate 910. For example, the substrate 910 is a Si substrate, and the input interconnect 921, the readout interconnect 922, the control interconnects 930, and the ground interconnects 940 are through silicon vias (TSVs). For example, the input interconnect 921 is electrically connected to the readout signal input/output interface 541 by a conductive bump 961, and the readout interconnect 922 is electrically connected to the readout signal input/output interface 441 by a conductive bump 962. The control interconnects 930 are electrically connected to the qubit control signal input interfaces 442 or 542 by conductive bumps 963, and the ground interconnects 940 are electrically connected to the ground interfaces 443 or 543 by conductive bumps 964. A package structure holding a substrate with an interposer may be used in place of the structure 900 with the interposer,.

A signal source 951 of a microwave signal is connected to input interconnect 921, and an amplifier, such as a TWPA 952, for example, is connected to readout interconnect 922. A qubit control device is connected to the control interconnects 930, and the ground interconnects 940 are grounded. The quantum computing system can be configured in the manner described above.

The readout from the quantum device 1 can also be performed using the structure 900 with the interposer having the configuration described above.

The input interconnect 921 may be electrically connected to the readout signal input/output interface 541, and the readout interconnect 922 may be electrically connected to the readout signal input/output interface 441, so that the signals propagate in opposite directions.

The input interconnect 921, the readout interconnect 922, the control interconnects 930, and the ground interconnects 940 do not necessarily have to be TSVs, and the structure 900 with the interposer may include a multilayer interconnection including interconnects parallel to a principal surface. It is possible to use a combination of the structure 900 with the interposer and a multilayer wiring board. It is possible to use a combination of the probe card 800 and the structure 900 with the interposer. Further, it is possible to use a combination of the probes that are coaxial pins having the mechanism for mechanical extension and retraction of the pins as in the first example and the structure with the interposer.

As described above, according to the quantum device 1, it is possible to perform multiplexed readout on the first qubit circuit 100 and the second qubit circuit. The number of qubits included in the first qubit circuit 100 and the number of qubits included in the second qubit circuit 200 are not particularly limited, and may be 1, 2, or 3, or may be 5 or greater.

In the case where the waveguide 350 includes the third resonator 330, antinodes of a standing wave are located at the first port coupling interface 311 and the second port coupling interface 312 by using the λ/2 resonator for the third resonator 330, and the signals can be propagated between the first port 110 and the second port 210 with a high efficiency. In addition, by adjusting an impedance of the third resonator 330, it is possible to match impedances between the first qubit circuit 100 and the second qubit circuit 200.

### <Second Embodiment>

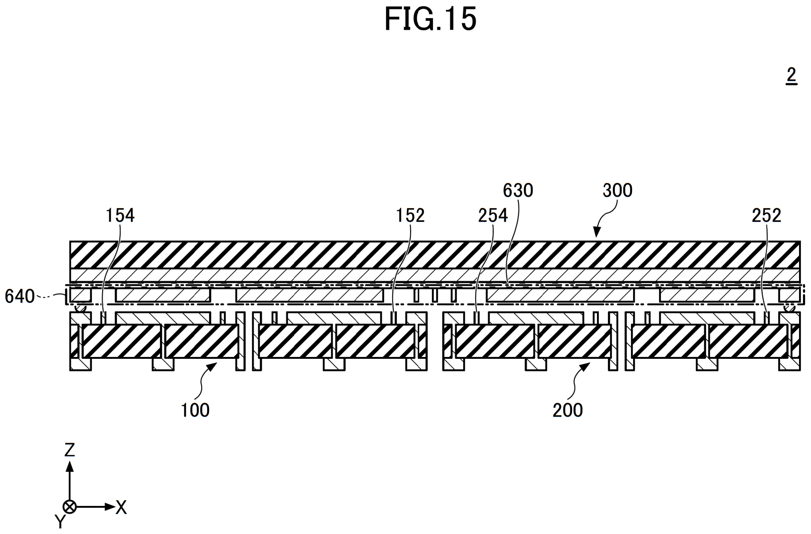

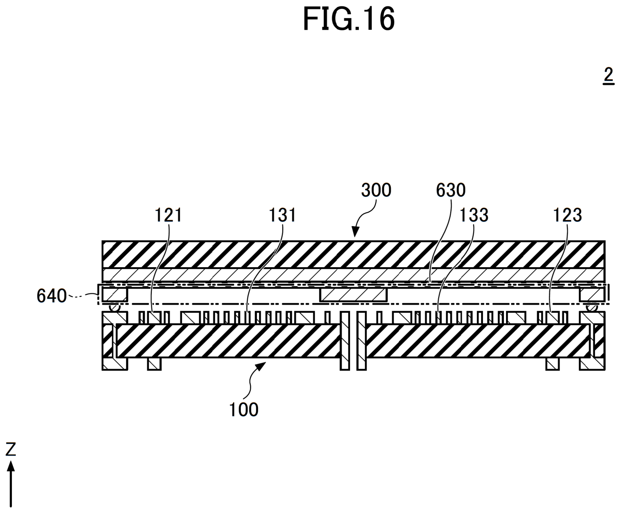

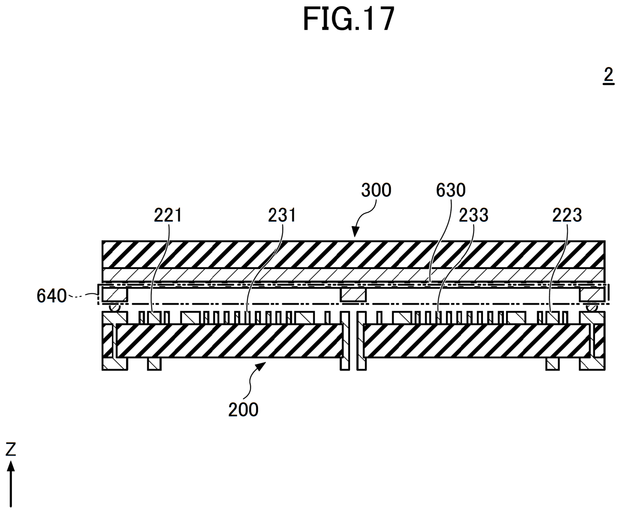

A second embodiment will be described. The second embodiment differs from the first embodiment mainly in the configuration of the conductive layer 640. FIG. 15, FIG. 16, and FIG. 17 are cross sectional views illustrating the quantum device according to the second embodiment.

As illustrated in FIG. 15 through FIG. 17, in a quantum device 2 according to the second embodiment, the conductive layer 640 does not have portions overlapping the qubits 121 through 124, overlapping the qubits 221 through 224, overlapping the resonators 131 through 134, overlapping the resonators 231 through 234, overlapping the bit-to-bit interconnects 151 through 154, and overlapping the bit-to-bit interconnects 251 through 254 in the plan view. The insulating film 630 is exposed on the +Z-side of the qubits 121 through 124, the qubits 221 through 224, the resonators 131 through 134, the resonators 231 through 234, the bit-to-bit interconnects 151 through 154, or the bit-to-bit interconnects 251 through 254. As described above, the quantum device 2 differs from the quantum device 1 mainly in the configuration of the conductive layer 640.

Otherwise, the configuration of the quantum device 2 is the same as that of the quantum device 1. The quantum device 2 can also obtain the same effects as those obtainable by the quantum device 1. Similar to in the first embodiment, a quantum computing system can be configured using the quantum device 2.

### <Third Embodiment>

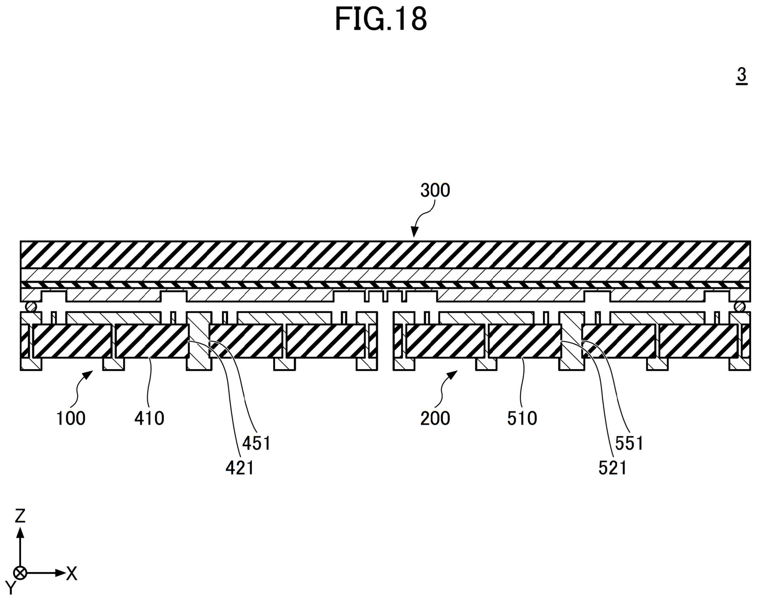

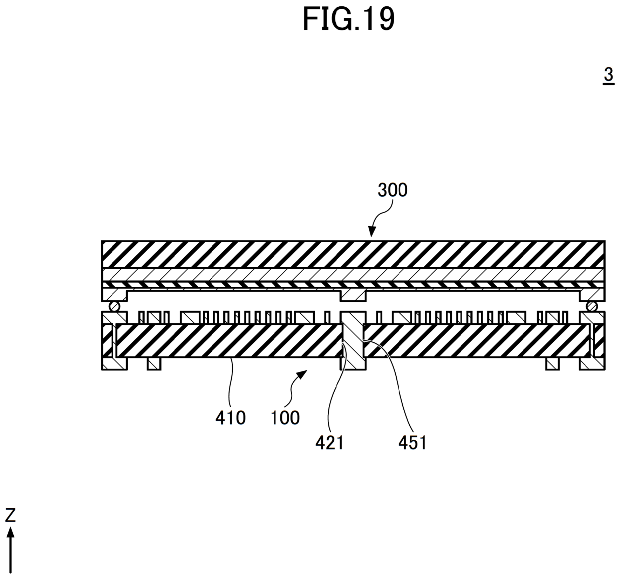

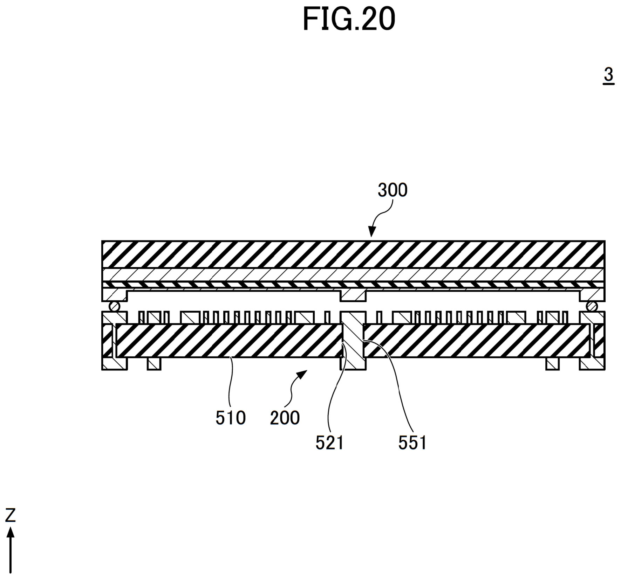

A third embodiment will be described. The third embodiment differs from the first embodiment mainly in the configurations of the first qubit circuit and the second qubit circuit. FIG. 18, FIG. 19, and FIG. 20 are cross sectional views illustrating the quantum device according to the third embodiment.

As illustrated in FIG. 18 through FIG. 20, in a quantum device 3 according to the third embodiment, the through hole 421 formed in the substrate 410 is closed by the conductive layer 451, and the through hole 521 formed in the substrate 510 is closed by the conductive layer 551. As described above, the quantum device 3 differs from the quantum device 1 mainly in the configurations of the first qubit circuit 100 and the second qubit circuit 200.

Otherwise, the configuration of the quantum device 3 is the same as that of the quantum device 1. The quantum device 3 can also obtain the same effects as those obtainable by the quantum device 1. Similar to the first embodiment, a quantum computing system can be configured using the quantum device 3.

### <Fourth Embodiment>

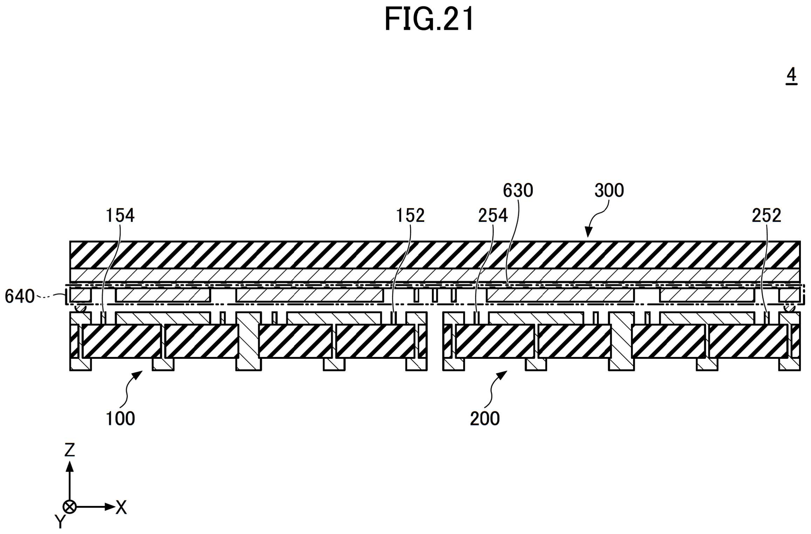

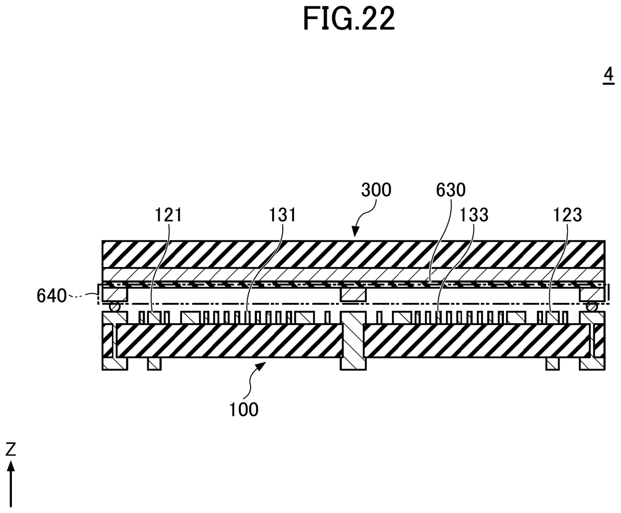

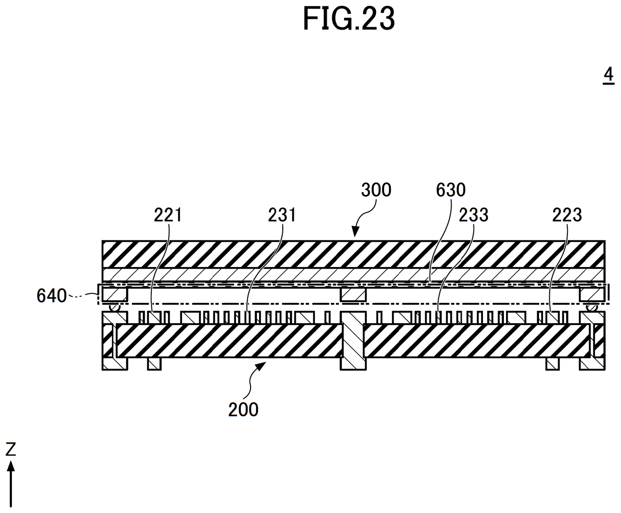

A fourth embodiment will be described. The fourth embodiment differs from the third embodiment mainly in the configuration of the conductive layer 640. FIG. 21, FIG. 22, and FIG. 23 are cross sectional views illustrating the quantum device according to the fourth embodiment.

As illustrated in FIG. 21 through FIG. 23, in a quantum device 4 according to the fourth embodiment, the conductive layer 640 does not include portions overlapping the qubits 121 through 124, overlapping the qubits 221 through 224, overlapping the resonators 131 through 134, overlapping the resonators 231 through 234, overlapping the bit-to-bit interconnects 151 through 154, and overlapping the bit-to-bit interconnects 251 through 254 in the plan view. The insulating film 630 is exposed on the +Z-side of the qubits 121 through 124, the qubits 221 through 224, the resonators 131 through 134, the resonators 231 through 234, the bit-to-bit interconnects 151 through 154, or the bit-to-bit interconnects 251 through 254. As described above, the quantum device 4 differs from the quantum device 3 mainly in the configuration of the conductive layer 640.

Otherwise, the configuration of the quantum device 4 is the same as that of the quantum device 3. The quantum device 4 can also obtain the same effects as those obtainable by the quantum device 3. Similar to the first embodiment, a quantum computing system can be configured using the quantum device 4.

### <Fifth Embodiment>

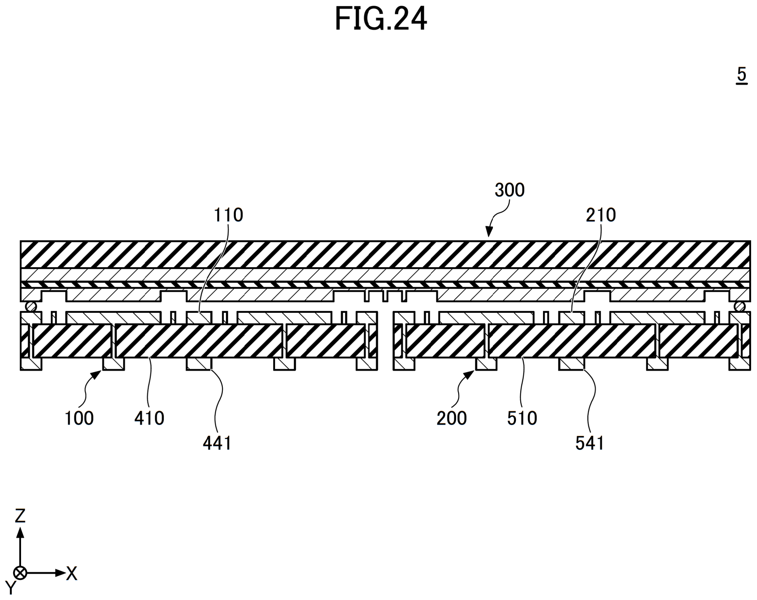

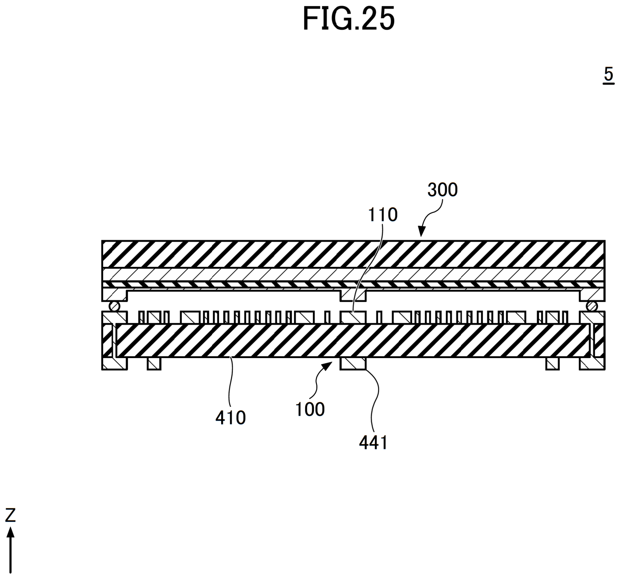

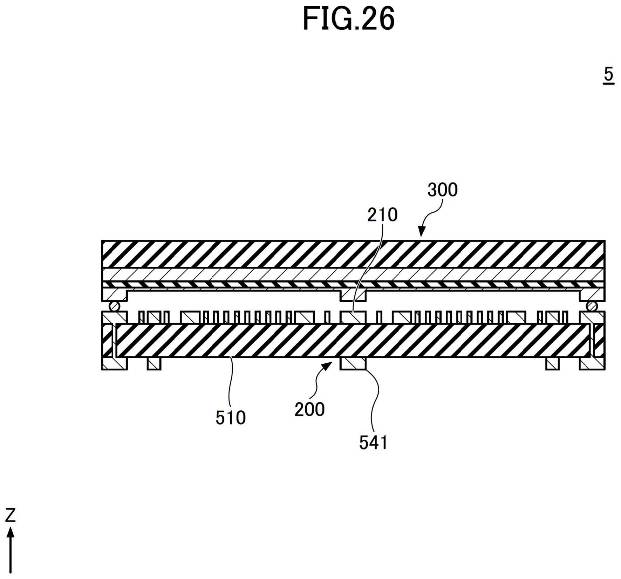

A fifth embodiment will be described. The fifth embodiment differs from the third embodiment mainly in the configurations of the first qubit circuit and the second qubit circuit. FIG. 24, FIG. 25, and FIG. 26 are cross sectional views illustrating the quantum device according to the fifth embodiment.

As illustrated in FIG. 24 through FIG. 26, in a quantum device 5 according to the fifth embodiment, the through hole 421 is not formed in the substrate 410, and the first qubit circuit 100 does not include the conductive layer 451. In addition, the through hole 521 is not formed in the substrate 510, and the second qubit circuit 200 does not include the conductive layer 551. In the first qubit circuit 100, the first port 110 and the readout signal input/output interface 441 are capacitively coupled to each other, and in the second qubit circuit 200, the second port 210 and the readout signal input/output interface 541 are capacitively coupled to each other. As described above, the quantum device 5 differs from the quantum device 3 mainly in the configurations of the first qubit circuit 100 and the second qubit circuit 200.

Otherwise, the configuration of the quantum device 5 is the same as that of the quantum device 3. The quantum device 5 can also obtain the same effects as those obtainable by the quantum device 3. Similar to the first embodiment, a quantum computing system can be configured using the quantum device 5.

### <Sixth Embodiment>

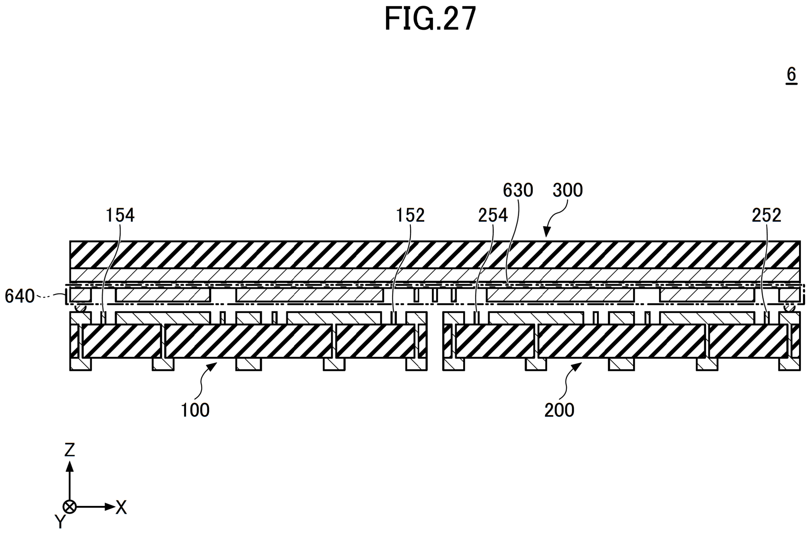

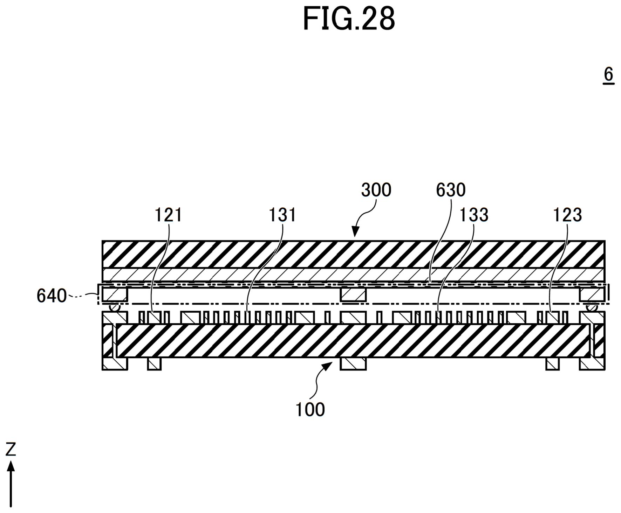

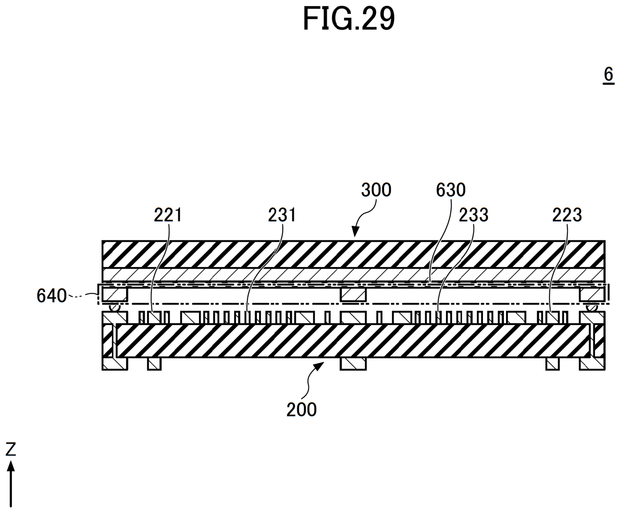

A sixth embodiment will be described. The sixth embodiment differs from the fifth embodiment mainly in the configuration of the conductive layer 640. FIG. 27, FIG. 28, and FIG. 29 are cross sectional views illustrating the quantum device according to the sixth embodiment.

As illustrated in FIG. 27 through FIG. 29, in a quantum device 6 according to the sixth embodiment, the conductive layer 640 does not include portions overlapping the qubits 121 through 124, overlapping the qubits 221 through 224, overlapping the resonators 131 through 134, overlapping the resonators 231 through 234, overlapping the bit-to-bit interconnects 151 through 154, and overlapping the bit-to-bit interconnects 251 through 254 in the plan view. The insulating film 630 is exposed on the +Z-side of the qubits 121 through 124, the qubits 221 through 224, the resonators 131 through 134, the resonators 231 through 234, the bit-to-bit interconnects 151 through 154, or the bit-to-bit interconnects 251 through 254. As described above, the quantum device 6 differs from the quantum device 5 mainly in the configuration of the conductive layer 640.

Otherwise, the configuration of the quantum device 6 is the same as that of the quantum device 5. The quantum device 6 can also obtain the same effects as those obtainable by the quantum device 5. Similar to the first embodiment, a quantum computing system can be configured using the quantum device 6.

### <Seventh Embodiment>

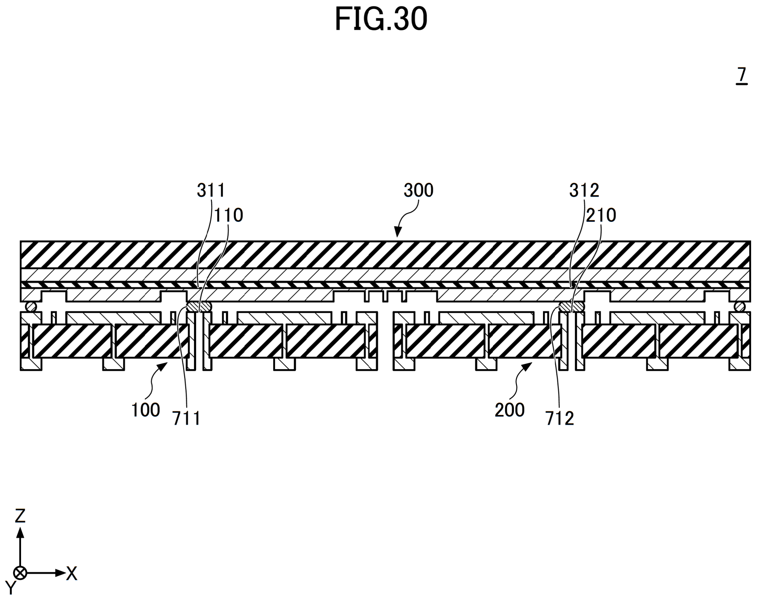

A seventh embodiment will be described. The seventh embodiment mainly differs from the first embodiment with regard to the coupling of the first port 110 and the first port coupling interface 311, and the coupling of the second port 210 and the second port coupling interface 312. FIG. 30 is a cross sectional view illustrating the quantum device according to the seventh embodiment.

As illustrated in FIG. 30, a quantum device 7 according to the seventh embodiment includes a conductive bump 711 that bonds (or joins) the first port 110 and the first port coupling interface 311, and a conductive bump 712 that bonds the second port 210 and the second port coupling interface 312. The first port 110 and the first port coupling interface 311 are galvanically coupled, that is, directly coupled, to each other. The second port 210 and the second port coupling interface 312 are galvanically coupled, that is, directly coupled, to each other. The waveguide 350 is directly coupled to the first port 110 and the second port 210. The conductive bumps 711 and 712 are formed of In, for example. The waveguide 350 may be a coplanar waveguide, for example. In addition, the waveguide 350 may include, as the third resonator 330, a λ/2 resonator having, as a third resonant frequency, an average value of the first resonant frequencies of the resonators 131 through 134 and the second resonant frequencies of the resonators 231 through 234. As described above, the quantum device 7 differs from the quantum device 1 mainly in the coupling between the first port 110 and the first port coupling interface 311 and the coupling between the second port 210 and the second port coupling interface 312.

Otherwise, the configuration of the quantum device 7 is the same as that of the quantum device 1. The quantum device 7 can also obtain the same effects as those obtainable by the quantum device 1. Similar to the first embodiment, a quantum computing system can be configured using the quantum device 7.

### <Eighth Embodiment>

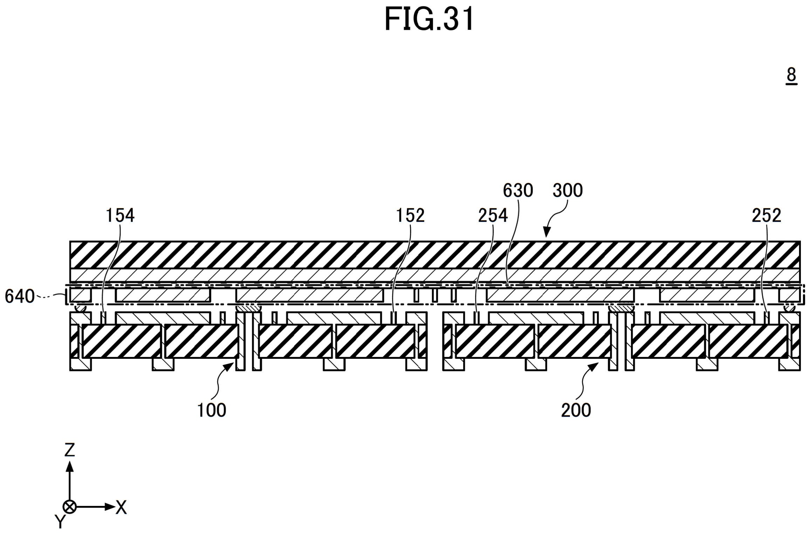

An eighth embodiment will be described. The eighth embodiment differs from the second embodiment mainly in the coupling between the first port 110 and the first port coupling interface 311 and the coupling between the second port 210 and the second port coupling interface 312. FIG. 31 is a cross sectional view illustrating the quantum device according to the eighth embodiment.

As illustrated in FIG. 31, a quantum device 8 according to the eighth embodiment includes a conductive bump 711 that bonds the first port 110 and the first port coupling interface 311, and a conductive bump 712 that bonds the second port 210 and the second port coupling interface 312. The first port 110 and the first port coupling interface 311 are galvanically coupled, that is, directly coupled, to each other. The second port 210 and the second port coupling interface 312 are galvanically coupled, that is, directly coupled, to each other. The waveguide 350 is directly coupled to the first port 110 and the second port 210. The waveguide 350 may be a coplanar waveguide, for example. In addition, the waveguide 350 may include, as the third resonator 330, a λ/2 resonator having, as a third resonant frequency, an average value of the first resonant frequencies of the resonators 131 through 134 and the second resonant frequencies of the resonators 231 through 234. As described above, the quantum device 8 differs from the quantum device 2 mainly in the coupling between the first port 110 and the first port coupling interface 311 and the coupling between the second port 210 and the second port coupling interface 312.

Otherwise, the configuration of the quantum device 8 is the same as that of the quantum device 2. The quantum device 8 can also obtain the same effects as those obtainable by the quantum device 2. Similar to the first embodiment, a quantum computing system can be configured using the quantum device 8.

### <Ninth Embodiment>

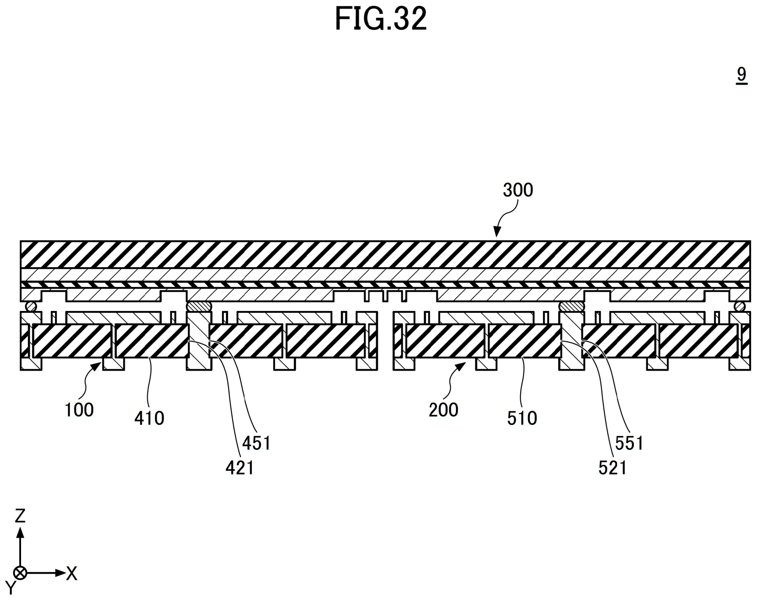

A ninth embodiment will be described. The ninth embodiment differs from the third embodiment mainly in the coupling between the first port 110 and the first port coupling interface 311 and the coupling between the second port 210 and the second port coupling interface 312. FIG. 32 is a cross sectional view illustrating the quantum device according to the ninth embodiment.

As illustrated in FIG. 32, a quantum device 9 according to the ninth embodiment includes a conductive bump 711 that bonds the first port 110 and the first port coupling interface 311, and a conductive bump 712 that bonds the second port 210 and the second port coupling interface 312. The first port 110 and the first port coupling interface 311 are galvanically coupled, that is, directly coupled, to each other. The second port 210 and the second port coupling interface 312 are galvanically coupled, that is, directly coupled, to each other. The waveguide 350 is directly coupled to the first port 110 and the second port 210. The waveguide 350 may be a coplanar waveguide, for example. In addition, the waveguide 350 may include, as the third resonator 330, a λ/2 resonator having, as a third resonant frequency, an average value of the first resonant frequencies of the resonators 131 through 134 and the second resonant frequencies of the resonators 231 through 234. As described above, the quantum device 9 differs from the quantum device 3 mainly in the coupling between the first port 110 and the first port coupling interface 311 and the coupling between the second port 210 and the second port coupling interface 312.

Otherwise, the configuration of the quantum device 9 is the same as that of the quantum device 3. The quantum device 9 can also obtain the same effects as those obtainable by the quantum device 3. Similar to the first embodiment, a quantum computing system can be configured using the quantum device 9.

### <Tenth Embodiment>

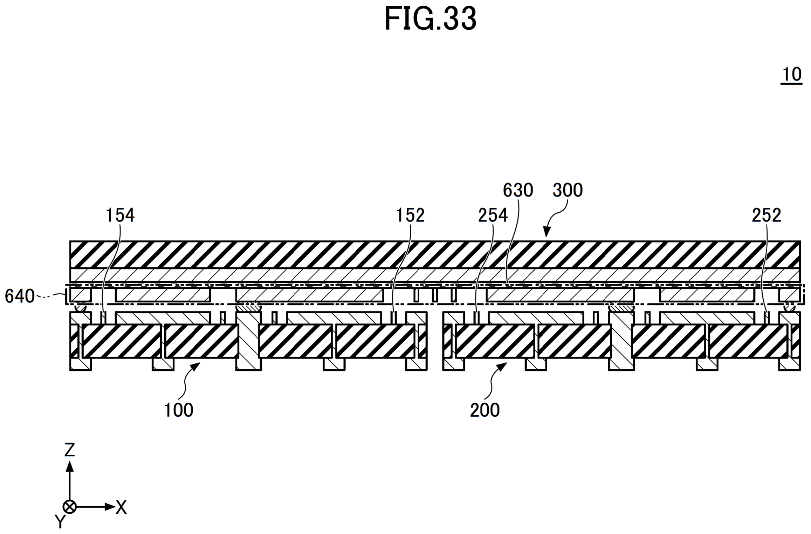

A tenth embodiment will be described. The tenth embodiment differs from the fourth embodiment mainly in the coupling between the first port 110 and the first port coupling interface 311 and the coupling between the second port 210 and the second port coupling interface 312. FIG. 33 is a cross sectional view illustrating the quantum device according to the tenth embodiment.

As illustrated in FIG. 33, a quantum device 10 according to the tenth embodiment includes a conductive bump 711 that bonds the first port 110 and the first port coupling interface 311, and a conductive bump 712 that bonds the second port 210 and the second port coupling interface 312. The first port 110 and the first port coupling interface 311 are galvanically coupled, that is, directly coupled, to each other. The second port 210 and the second port coupling interface 312 are galvanically coupled, that is, directly coupled, to each other. The waveguide 350 is directly coupled to the first port 110 and the second port 210. The waveguide 350 may be a coplanar waveguide, for example. In addition, the waveguide 350 may include, as the third resonator 330, a λ/2 resonator having, as a third resonant frequency, an average value of the first resonant frequencies of the resonators 131 through 134 and the second resonant frequencies of the resonators 231 through 234. As described above, the quantum device 10 differs from the quantum device 4 mainly in the coupling between the first port 110 and the first port coupling interface 311 and the coupling between the second port 210 and the second port coupling interface 312.

Otherwise, the configuration of the quantum device 10 is the same as that of the quantum device 4. The quantum device 10 can also obtain the same effects as those obtainable by the quantum device 4. Similar to the first embodiment, a quantum computing system can be configured using the quantum device 10.

### <Eleventh Embodiment>

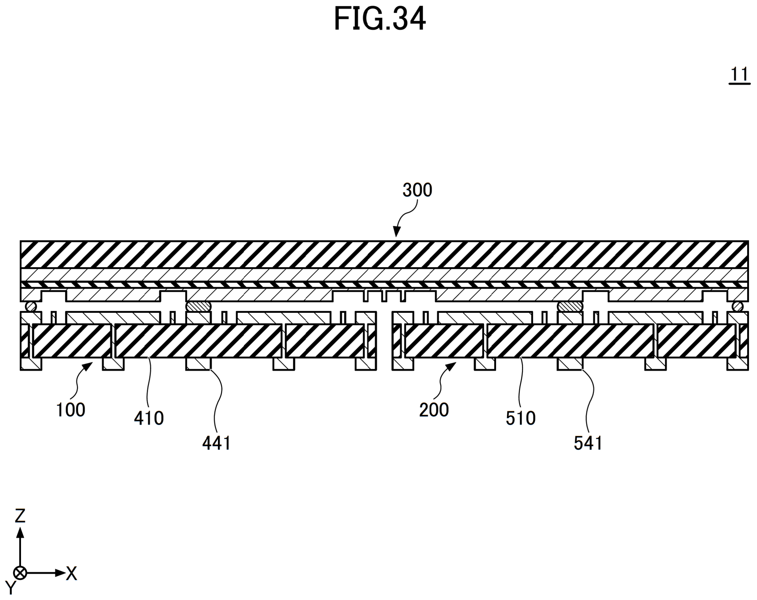

An eleventh embodiment will be described. The eleventh embodiment differs from the fifth embodiment mainly in the coupling between the first port 110 and the first port coupling interface 311 and the coupling between the second port 210 and the second port coupling interface 312. FIG. 34 is a cross sectional view illustrating the quantum device according to the eleventh embodiment.

As illustrated in FIG. 34, a quantum device 11 according to the eleventh embodiment includes a conductive bump 711 that bonds the first port 110 and the first port coupling interface 311, and a conductive bump 712 that bonds the second port 210 and the second port coupling interface 312. The first port 110 and the first port coupling interface 311 are galvanically coupled, that is, directly coupled, to each other. The second port 210 and the second port coupling interface 312 are galvanically coupled, that is, directly coupled, to each other. The waveguide 350 is directly coupled to the first port 110 and the second port 210. The waveguide 350 may be a coplanar waveguide, for example. In addition, the waveguide 350 may include, as the third resonator 330, a λ/2 resonator having, as a third resonant frequency, an average value of the first resonant frequencies of the resonators 131 through 134 and the second resonant frequencies of the resonators 231 through 234. As described above, the quantum device 11 differs from the quantum device 5 mainly in the coupling between the first port 110 and the first port coupling interface 311 and the coupling between the second port 210 and the second port coupling interface 312.

Otherwise, the configuration of the quantum device 11 is the same as that of the quantum device 5. The quantum device 11 can also obtain the same effects as those obtainable by the quantum device 5. Similar to the first embodiment, a quantum computing system can be configured using the quantum device 11.

### <Twelfth Embodiment>

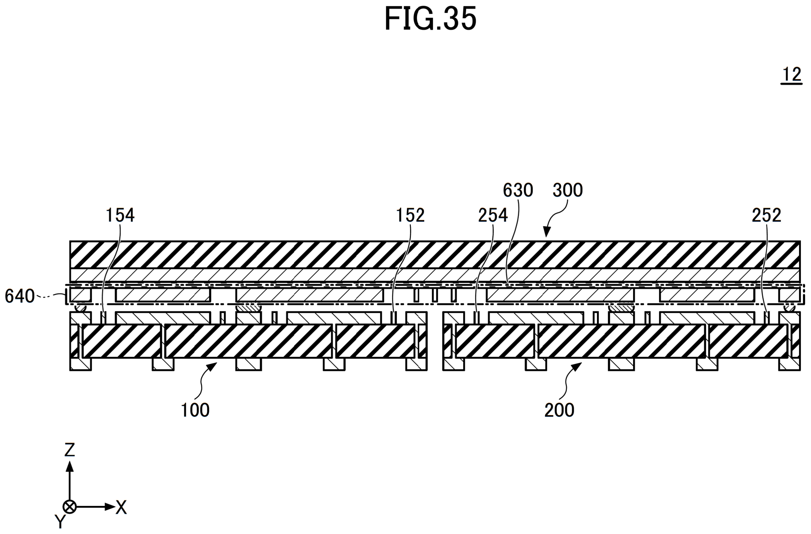

A twelfth embodiment will be described. The twelfth embodiment differs from the sixth embodiment mainly in the coupling between the first port 110 and the first port coupling interface 311 and the coupling between the second port 210 and the second port coupling interface 312. FIG. 35 is a cross sectional view illustrating the quantum device according to the twelfth embodiment.

As illustrated in FIG. 35, a quantum device 12 according to the twelfth embodiment includes a conductive bump 711 that bonds the first port 110 and the first port coupling interface 311, and a conductive bump 712 that bonds the second port 210 and the second port coupling interface 312. The first port 110 and the first port coupling interface 311 are galvanically coupled, that is, directly coupled, to each other. The second port 210 and the second port coupling interface 312 are galvanically coupled, that is, directly coupled, to each other. The waveguide 350 is directly coupled to the first port 110 and the second port 210. The waveguide 350 may be a coplanar waveguide, for example. In addition, the waveguide 350 may include, as the third resonator 330, a λ/2 resonator having, as a third resonant frequency, an average value of the first resonant frequencies of the resonators 131 through 134 and the second resonant frequencies of the resonators 231 through 234. As described above, the quantum device 12 differs from the quantum device 6 mainly in the coupling between the first port 110 and the first port coupling interface 311 and the coupling between the second port 210 and the second port coupling interface 312.

Otherwise, the configuration of the quantum device 12 is the same as that of the quantum device 6. The quantum device 12 can also obtain the same effects as those obtainable by the quantum device 6. Similar to the first embodiment, a quantum computing system can be configured using the quantum device 12.

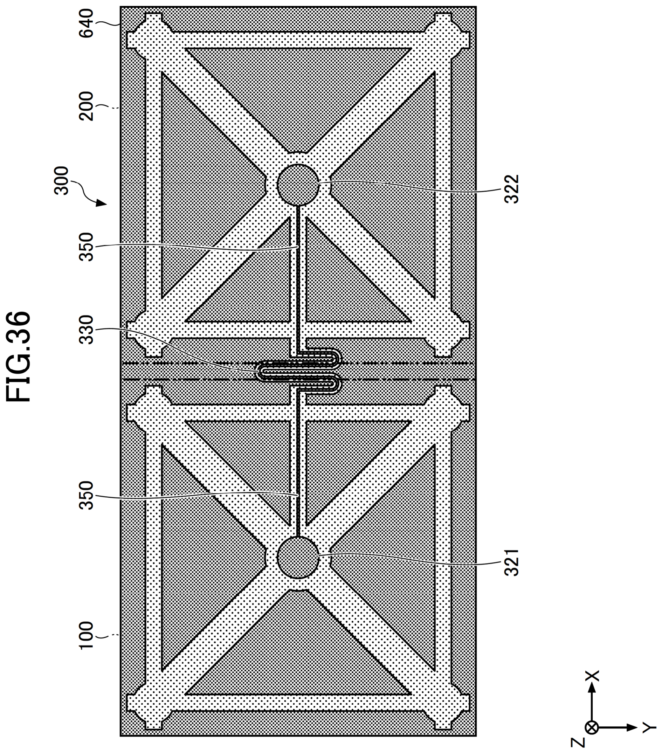

In each of the embodiments described above, a configuration illustrated in FIG. 36 may be employed, so that there exists a region where the ground interface 360 is not locally provided in the periphery of the waveguide 350. This configuration enables a layout design according to the configurations of the first qubit circuit 100 and the second qubit circuit 200. For example, by forming a shape of an antenna element in accordance with a coupler that couples the qubits, it is possible to prevent electromagnetic radiation. In addition, a characteristic impedance of the waveguide 350 may be less than 50 Q. By designing the configuration with a layout according to the first qubit circuit 100 and the second qubit circuit 200, it is possible to prevent the electromagnetic radiation. The impedance can be adjusted by varying the width of the waveguide 350. FIG. 36 is a bottom view illustrating a first modification of the cover chip.

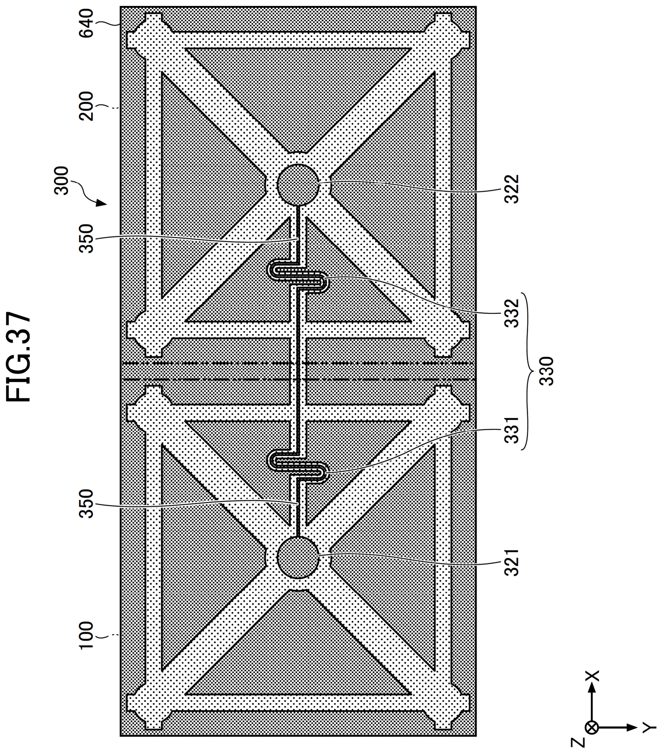

In each of the embodiments described above, the third resonator 330 may be divided into a plurality of resonators. For example, as illustrated in FIG. 37, the third resonator 330 may include a fourth resonator 331 and a fifth resonator 332. For example, in the plan view, the fourth resonator 331 may be located closer to the first port 110 than to the bit-to-bit interconnect 152 of the first qubit circuit 100, and the fifth resonator 332 may be located closer to the second port 210 than to the bit-to-bit interconnect 254 of the second qubit circuit 200. FIG. 37 is a bottom view illustrating a second modification of the cover chip.

In each of the embodiments described above, in a structure formed by processing the conductive layer 640 or additionally forming and processing a superconducting material by vapor deposition or sputtering, a thickness of the superconducting material may be made to vary in the Z-axis direction. For example, the thickness of the superconducting material at the first port coupling interface 311 and the second port coupling interface 312 of the conductive layer 640 may be larger than the thickness at the waveguide 350. In this case, by reducing the distances of the first port coupling interface 311 and the second port coupling interface 312 from the first port 110 and the second port 210, respectively, while increasing the distance of the waveguide 350 from the first qubit circuit 100 and the second qubit circuit 200, it becomes easy to create a structure that confines radiation from the first qubit circuit 100 and the second qubit circuit 200 while increasing a magnitude of the capacitive coupling. In addition, in the case where the first port 110 and the first port coupling interface 311 are galvanically coupled and the second port 210 and the second port coupling interface 312 are galvanically coupled, a height of the bump 711 used when connecting the first port 110 and the first port coupling interface 311 and a height of the bump 712 used when connecting the second port 210 and the second port coupling interface 312 can be suppressed, and thus, the galvanic coupling can be stably achieved.

In the first through sixth embodiments, the thickness of the superconducting material at the first port coupling interface 311 and the second port coupling interface 312 of the conductive layer 640 is preferably smaller than the thickness at the ground interface 360. In this case, it is easy to electrically connect the ground interface 360 to the ground interfaces 160 and 260 while capacitively coupling the first port coupling interface 311 and the second port coupling interface 312 to the first port 110 and the second port 210, respectively. In the seventh through twelfth embodiments, because the first port coupling interface 311 and the second port coupling interface 312 are electrically connected to the first port 110 and the second port 210, respectively, the thickness of the superconducting material at the first port coupling interface 311 and the second port coupling interface 312 of the conductive layer 640 may be the same as the thickness at the ground interface 360.

In each of the embodiments described above, the cover chip 300 does not necessarily have to include the shield layer 620 and the insulating film 630. Moreover, the waveguide 350 may be a microstrip line. That is, a shield layer may be provided on the upper surface 611. In this case, a shield layer is preferably provided also on a side surface of the substrate 610 to prevent radiation to the outside.

In each of the embodiments described above, the first qubit circuit 100 and the second qubit circuit 200 are not limited to being provided on the same chip. For example, the first qubit circuit 100 including the first port 110 and the second qubit circuit 200 including the second port 210 may be provided on different chips, and the first port 110 and the second port 210 may be directly or indirectly coupled via the cover chip 300. In this case, couplers may be provided between the qubits 121 through 124 and the qubits 221 through 224, respectively.

The quantum device, the quantum computing system, and the quantum device readout method according to the present disclosure can be used for quantum computing, for example.

According to the present disclosure, it is possible to perform multiplexed readout on a plurality of qubit circuits.

Although the embodiments are numbered with, for example, "first," "second," ... or "twelfth," the ordinal numbers do not imply priorities of the embodiments. Many other variations and modifications will be apparent to those skilled in the art.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A quantum device (1-12) comprising:
a first qubit circuit (100);
a second qubit circuit (200); and
a cover chip (300), wherein:
the first qubit circuit (100) includes:
a first port (110);
a first qubit (121-124); and
a first resonator (131-134) coupled to the first qubit (121-124) and the first port (110) and having a first resonant frequency;
the second qubit circuit (200) includes:
a second port (210);
a second qubit (221-224); and
a second resonator (231-234) coupled to the second qubit (221-224) and the second port (210) and having a second resonant frequency different from the first resonant frequency, and
the cover chip (300) includes a waveguide (350) coupled to the first port (110) and the second port (210).

2. The quantum device (1-12) as claimed in claim 1, wherein:
the first qubit circuit (121-124) includes a plurality of sets of the first qubit and the first resonator,
the second qubit circuit (221-224) includes a plurality of sets of the second qubit and the second resonator, and
the first resonant frequency and the second resonant frequency differ among a plurality of first resonators and a plurality of second resonators.

3. The quantum device (1-12) as claimed in claim 1 or 2, wherein the waveguide (350) includes a third resonator (330) having a third resonant frequency.

4. The quantum device (1-12) as claimed in claim 3, wherein the third resonant frequency is fₐᵥₑ × 0.7 or higher and fₐᵥₑ × 1.3 or lower, where fₐᵥₑ denotes an average value of the first resonant frequency and the second resonant frequency.

5. The quantum device (1-12) as claimed in claim 3 or 4, wherein the third resonator (330) has a meander shape in a plan view.

6. The quantum device (1-12) as claimed in any one of claims 1 to 5, wherein:
the first qubit circuit (121-124) includes a first filter (140) coupled between the first port (110) and the first resonator (131-134), and
the second qubit circuit (221-224) includes a second filter (240) coupled between the second port (210) and the second resonator (231-234).

7. The quantum device (1-12) as claimed in any one of claims 1 to 6, wherein:
the cover chip (300) includes a substrate (610) and an insulating film (630), and
the insulating film (630) is located between the substrate (610) and the waveguide (350).

8. The quantum device (1-6, 8-12) as claimed in any one of claims 1 to 7, wherein the first port (110) and the second port (210) are capacitively coupled to the waveguide (350).

9. The quantum device (7) as claimed in any one of claims 1 to 7, wherein the first port (110) and the second port (210) are galvanically coupled to the waveguide (350).

10. A quantum computing system comprising:
the quantum device (1-12) according to any one of claims 1 to 9; and
a traveling-wave parametric amplifier (852,952) coupled to either the first port (110) or the second port (210).

11. A readout method for a quantum device (1-12), comprising:
inputting a microwave signal to the first port (110) of the quantum device (1-12) according to any one of claims 1 to 9; and
measuring a signal output from the second port (210).

12. The readout method for the quantum device (1-12) as claimed in claim 11, further comprising:
amplifying the signal output from the second port (210) by a traveling-wave parametric amplifier (852, 952) between the inputting the microwave signal and the measuring the signal.
